# FASCICULE DE BREVET EUROPEEN

(11) **EP 1 924 889 B1**
(45) Date de publication et mention de la délivrance du brevet: **14.01.2009**
(21) Numéro de dépôt: 06793241.8
(22) Date de dépôt: 05.09.2006
(51) Int. Cl.: G03F 7/20

(54) **ILLUMINATEUR D'UN DISPOSITIF DE PHOTOLITHOGRAPHIE**
BELEUCHTUNGSVORRICHTUNG EINER FOTOLITHOGRAPHIEVORRICHTUNG
ILLUMINATOR FOR A PHOTOLITHOGRAPHY DEVICE

(30) Priorité: 05.09.2005 FR 0509036
(43) Date de publication de la demande: 28.05.2008
(73) Titulaire: SAGEM Défense Sécurité, 75015 Paris (FR); Shanghai Micro Electronics Equipment Co., Ltd., Shanghai 201203 (CN)
(72) Inventeur: BOUTONNE, Miguel, F-75015 Paris (FR); MERCIER YTHIER, Renaud, F-75015 Paris (FR); RIGUET, François, F-75015 Paris (FR)
(74) Mandataire: Callon de Lamarck, Jean-Robert
(86) Numéro de dépôt international: PCT/EP2006/066032
(87) Numéro de publication internationale: WO 2007/028793

(56) Documents cités:
- US-A- 4 497 015
- US-A- 5 130 213
- US-A- 5 991 009
- PATENT ABSTRACTS OF JAPAN vol. 011, no. 231 (E-527), 28 juillet 1987 (1987-07-28) -& JP 62 047124 A (CANON INC), 28 février 1987 (1987-02-28)
- PATENT ABSTRACTS OF JAPAN vol. 1995, no. 08, 29 septembre 1995 (1995-09-29) -& JP 07 120850 A (ADTEC ENG:KK; others: 01), 12 mai 1995 (1995-05-12)
- PATENT ABSTRACTS OF JAPAN vol. 013, no. 453 (E-831), 11 octobre 1989 (1989-10-11) -& JP 01 175730 A (MATSUSHITA ELECTRIC IND CO LTD), 12 juillet 1989 (1989-07-12)

## Description

### DOMAINE TECHNIQUE GENERAL

La présente invention concerne un illuminateur d'un dispositif de photolithographie, ainsi qu'un tel dispositif.

### ETAT DE L'ART

La photolithographie - également appelée « microlithographie » - est utilisée depuis de nombreuses années pour la fabrication de dispositifs semiconducteurs et utilise pour cela un rayonnement électromagnétique pour générer des motifs fins sur les dispositifs semiconducteurs. A cet effet, un illuminateur d'un dispositif de photolithographie illumine un masque dont l'image est projetée sur une tranche semiconductrice (ou « wafer » selon la terminologie anglo-saxonne généralement utilisée par l'homme du métier) qui fournit un circuit après un traitement ad hoc connu de l'homme de l'art.

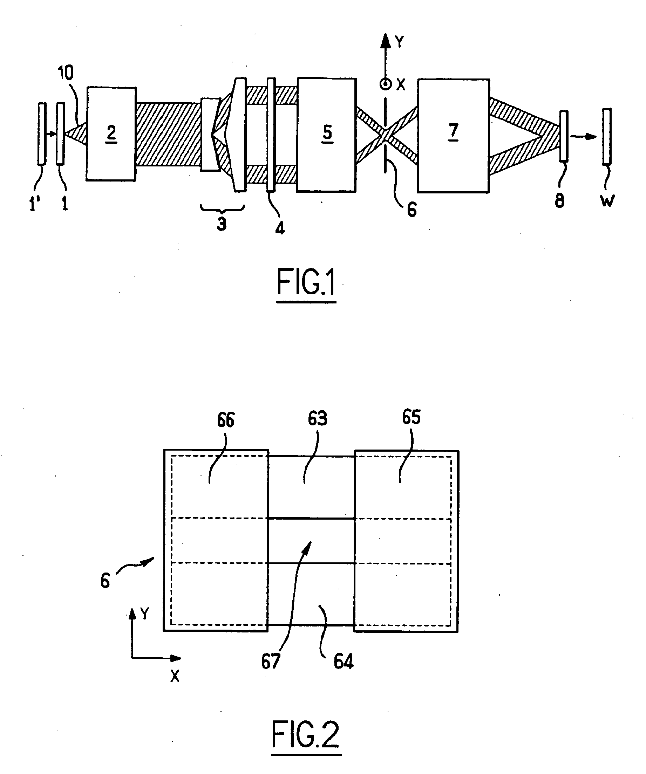

Comme le montre la figure 1, le système d'illumination - appelé « illuminateur » dans la suite de la présente description - d'un dispositif de photolithographie est complexe. Il doit prendre en compte plusieurs paramètres simultanément pour satisfaire les besoins de la microlithographie. Les paramètres dont il s'agit sont notamment :
- le profil d'éclairement dans la pupille du dispositif ;
- l'uniformité d'éclairement sur le masque (et donc la tranche) ; et
- le profil d'illumination sur le masque.

A cet effet, un illuminateur connu comporte généralement un élément optique diffractif 1 (également appelé « diffractive optical element » ou DOE en anglais) qui est illuminé par une source 1' d'illumination. L'élément 1 peut être n'importe quel élément généralement utilisé pour produire de la diffraction, comme par exemple un réseau en deux dimensions de microlentilles sphériques, une lentille de Fresnel, un réseau de diffraction, etc. L'élément 1 joue le rôle d'un diffuseur optique et a pour fonction principale de produire à sa sortie une pupille de motif général voulu, par exemple un motif en forme de disque ou d'anneau, ou encore un motif dipolaire ou quadripolaire. L'élément 1 est interchangeable, car un élément 1 d'un type donné ne peut générer qu'un seul motif à la fois.

L'illuminateur comporte en sortie de l'élément 1 un zoom 2 formé de plusieurs lentilles. La fonction du zoom 2 est de ramener l'image de la pupille à une distance finie et de pouvoir la faire varier en dimension.

La sortie du zoom 2 est dirigée vers des axicons 3 qui donnent sa forme définitive à la pupille. Par exemple, dans le cas d'axicons composés de lentilles coniques, on peut contrôler le diamètre intérieur d'une pupille en forme d'anneau.

L'ensemble formé de l'élément 1 - du zoom 2 - des axicons 3 permet donc d'obtenir un profil d'éclairement voulu dans la pupille.

Le faisceau lumineux sortant des axicons 3 illumine un élément optique 4. L'élément 4 est généralement constitué de deux matrices formées d'un réseau en deux dimensions de microlentilles cylindriques qui découpe la pupille obtenue en sortie de l'ensemble élément 1 - zoom 2 - axicons 3. La pupille du zoom 2 se retrouve au niveau de l'élément 4 dont la sortie illumine un condenseur 5.

Le condenseur 5 comporte une pluralité de lentilles qui permettent de superposer au niveau de l'obturateur 6 les sous faisceaux issus de l'élément diffractif 4.

L'ensemble élément 4 - condenseur 5 uniformise l'éclairement dans le plan d'un obturateur 6.

En effet, la sortie du condenseur 5 illumine un obturateur 6 (également appelé « slit » en anglais). L'obturateur 6 permet de façon connue d'obturer le faisceau lumineux issu du condenseur 5.

L'obturateur 6 permet de contrôler la dose, le format image, et le profil d'illumination sur un masque 8 grâce notamment à un groupe 7 de lentilles d'illumination (ou « Illumination Lens Group » (ILG)) placé en sortie de l'obturateur 6.

L'obturateur 6 comporte, comme le montre la figure 2, notamment deux plaques 63 et 64 fixes. Les plaques 63 et 64 sont rectangulaires, et leur longueur s'étend sensiblement selon la direction X. Les plaques 63 et 64 sont immobiles par rapport à l'illumination, notamment par rapport aux directions X et Y de la figure 2. Les plaques 63 et 64 sont distantes l'une de l'autre selon la direction Y et définissent deux bords d'une aire d'exposition 67.

L'obturateur 6 comporte également deux plaques 65 et 66 mobiles par rapport à l'illumination dans la direction X. Les plaques 65 et 66 sont rectangulaires, et leur longueur s'étend sensiblement selon la direction Y. Lorsque les plaques 65 et 66 sont distantes l'une de l'autre selon la direction X, elles définissent deux bords de l'aire 67.

L'espace entre les plaques 63, 64, 65 et 66 définit ainsi l'aire 67 d'exposition à l'illumination pour la gravure de la tranche.

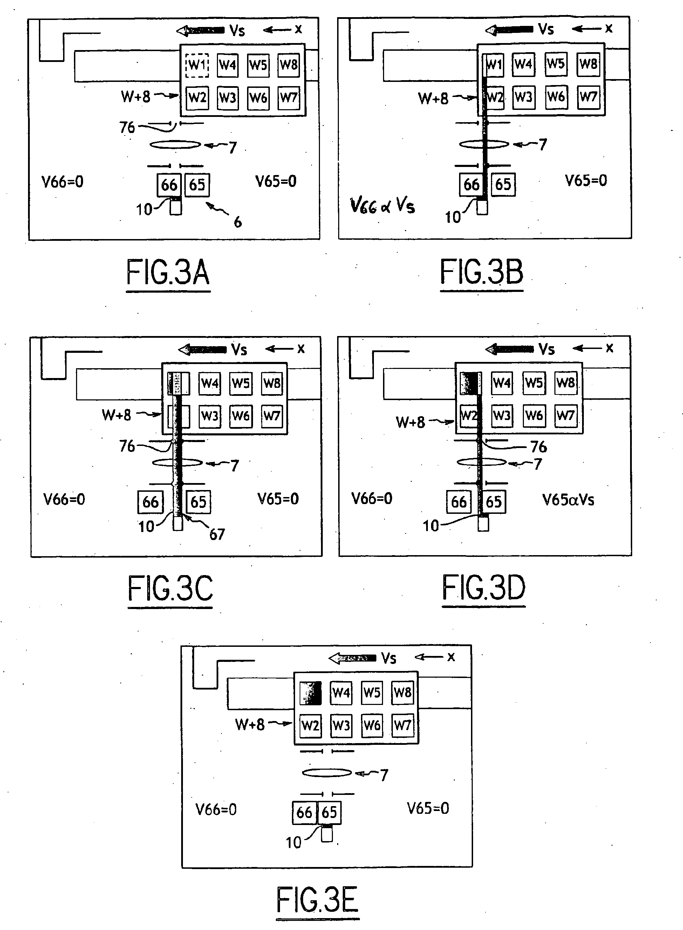

Les figures 3A à 3E montrent le fonctionnement de l'obturateur 6 de l'art antérieur.

Lors du déplacement connu du masque 8 et de la tranche W l'un par rapport à l'autre pour une exposition en vue d'une gravure, il ne faut pas que des points en dehors de la zone W1 à graver de la tranche reçoivent de l'énergie d'exposition. A cet effet, on synchronise notamment le déplacement des plaques 65 et 66 avec les déplacements du masque 8 et de la tranche W.

Sur les figures 3A à 3E, on a représenté pour plus de clarté que le masque 8 était situé sur la tranche W. Bien entendu, le masque est optiquement situé au droit de la tranche W. La figure 3A montre que lorsque la tranche W et le masque 8 se déplacent selon la direction X mais se trouvent en dehors de la zone d'exposition 76 définie par le relais 7, alors les plaques 66 et 65 sont fermées. L'aire 67 est nulle et le faisceau 10 est bloqué par l'obturateur 6.

La figure 3B montre que lorsque le bord gauche du masque 8 définissant la première zone W1 de la tranche W à exposer arrive au niveau du bord droit de la plaque 66 en dépassant le bord droit de la zone 76, alors la plaque 66 commence un déplacement en synchronisme et dans le même sens que le masque 8 avec une vitesse en synchronisme avec la vitesse Vs de la tranche W et du masque 8. En d'autres termes, la vitesse de la plaque 66 est proportionnelle à la vitesse Vs. Les zones de la tranche W situées en dehors de la zone W1 à exposer ne sont ainsi pas exposées au faisceau 10.

La figure 3C montre que la plaque 66 suit le masque 8 jusqu'à ce que le bord gauche du masque 8 soit situé au niveau du bord gauche de la zone d'exposition 76. L'aire 67 est alors maximale et l'ensemble du faisceau 10 expose la zone W à travers la zone 76.

La figure 3D montre que c'est alors la plaque 65 qui suit le masque 8 dans le même sens que le masque 8 sur la direction X lorsque le bord droit du masque dépasse le bord droit de la zone 76. Encore une fois, le déplacement de la plaque 65 s'effectue en synchronisme avec les déplacements de la tranche W et du masque 8, à savoir dans le même sens et avec une vitesse proportionnelle à la vitesse Vs de la tranche W. De cette manière, les zones de la tranche W situées en dehors de la zone W1 ne sont pas exposées au faisceau 10.

La figure 3E correspond à la fermeture de l'aire 67 d'exposition, les plaques 65 et 66 sont alors jointives. La zone W1 est en dehors de la zone 76 et le faisceau 10 est bloqué par l'obturateur.

Lors du déplacement du masque dans l'autre sens selon X, par exemple pour une exposition des zones W2 à W8, les plaques 65 et 66 se déplacent bien entendu dans l'autre sens. L'obturation peut s'effectuer à une vitesse d'environ 160 mm/s.

Grâce à ce procédé d'ouverture et de fermeture des plaques 65 et 66, tous les points de la zone à graver reçoivent la même énergie d'exposition et les zones ne devant pas être exposées ne le sont pas.

Le groupe 7 forme un relais optique qui conjugue le plan de l'obturateur 6 et le masque 8. En fait, sans le groupe 7, l'obturateur 6 et le masque 8 devraient être situés dans le même plan, ce qui est impossible du point de vue mécanique dans le montage de la figure 1. Il y aurait notamment un frottement des plaques 65 et 66 contre le masque 8.

Les illuminateurs de l'art antérieur présentent des inconvénients.

L'illuminateur selon l'art antérieur est compliqué et onéreux à fabriquer, du fait notamment de la présence d'un groupe 7 formant un relais optique pour conjuguer le plan de l'obturateur et le masque. La complexité d'un tel groupe est à la fois optique et mécanique.

De plus, les éléments mécaniques permettant le déplacement des plaques mobiles de l'obturateur sont complexes et onéreux, du fait de la grande amplitude de la course et de la grande vitesse de translation des plaques (environ 160 mm/s).

Amendements introduits par la division d'examen le 05/03/2008- EP 06793241

Le document JP 62047124 divulgue un appareil d'exposition doté de deux plaques d'obturation situées en aval d'un réseau principal de microlentilles. Ces deux plaques sont déplacées l'une par rapport à l'autre de telle sorte que la lumière d'exposition soit bloquée ou projetée sur le masque. Un contrôleur et des moyens de déplacement font en sorte que lesdites plaques sont aptes à être déplacées en synchronisme avec les déplacements du masque et de la branche. Le document JP 62047124 divulgue également la présence d'un obturateur (shutter) en aval du réseau principal de microlentilles.

Le document JP 07120850 divulgue un appareil d'exposition comportant deux plaques d'obturation situées en aval d'un réseau de microlentilles. Le déplacement de l'une de ces deux plaques permet d'obturer le faisceau lumineux d'exposition ou bien de le laisser passer, l'autre plaque demeurant immobile.

### PRESENTATION DE L'INVENTION

L'invention propose de pallier au moins un de ces inconvénients.

A cet effet, on propose selon l'invention un illuminateur selon la revendication 1.

L'invention est avantageusement complétée par les caractéristiques présentées dans les revendications dépendantes.

L'invention concerne également un dispositif comportant un tel illuminateur.

L'invention présente de nombreux avantages.

Tout d'abord, un illuminateur selon l'invention est plus simple et par conséquent moins onéreux à fabriquer, du fait de l'absence d'un groupe formant un relais optique pour conjuguer le plan de l'obturateur et le masque.

De plus, les éléments mécaniques permettant le déplacement des plaques mobiles les unes par rapport aux autres sont également plus simples et par conséquent moins onéreux, du fait de la diminution de l'amplitude de la course et de la vitesse de translation des plaques. On peut atteindre une diminution d'un facteur 10 de la vitesse de déplacement des plaques de l'obturateur, ce qui permet une diminution des vibrations induites dans le dispositif de photolithographie ainsi qu'une simplification des moyens de déplacement de l'obturateur.

Un illuminateur selon l'invention permet notamment de corriger certains défauts de l'illumination dus à la nature de la source de l'illumination, notamment lorsque la source est un laser. Un illuminateur selon l'invention permet d'obtenir un profil d'illumination trapézoïdal selon la direction de déplacement du masque et de la tranche.

Un illuminateur selon l'invention permet notamment également une coupure franche de l'illumination.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- la figure 1, déjà commentée, représente schématiquement un illuminateur connu de l'état de la technique ;
- la figure 2 déjà commentée également, représente un obturateur connu de l'état de l'art ;
- les figures 3A à 3E, déjà commentées, représentent schématiquement les différentes phases de déplacement de plaques de l'obturateur selon la figure 2 en fonction du déplacement d'un masque disposé dans un illuminateur selon la figure 1 ;
- les figures 4A et 4B représentent schématiquement respectivement une plaque d'un obturateur selon l'invention ;
- la figure 5 représente schématiquement une disposition possible des deux plaques des figures 4A et 4B ;
- la figure 6 représente schématiquement une première position de l'obturateur dans un illuminateur selon l'invention ;
- la figure 7 représente schématiquement une deuxième position de l'obturateur dans un illuminateur selon l'invention ;
- la figure 8 représente schématiquement une variante de l'invention comportant deux plaques d'obturation ;
- les figures 9A à 9F représentent schématiquement un mode de fonctionnement possible d'une variante selon la figure 8 ;
- la figure 10 représente schématiquement une variante de l'invention comportant deux plaques croisées ;
- la figure 11 représente schématiquement une variante de l'invention comportant une plaque d'obturation et une plaque croisée mobiles ;
- les figures 12 et 13 représentent schématiquement une variante de l'invention comportant un réseau de création d'une pupille image de la pupille du réseau principal ; et
- la figure 14 représente schématiquement une variante de l'invention comportant un masque défocalisé par rapport à un plan de focalisation d'un condenseur.

Sur l'ensemble des figures, les éléments similaires portent des références numériques identiques.

### DESCRIPTION DETAILLEE

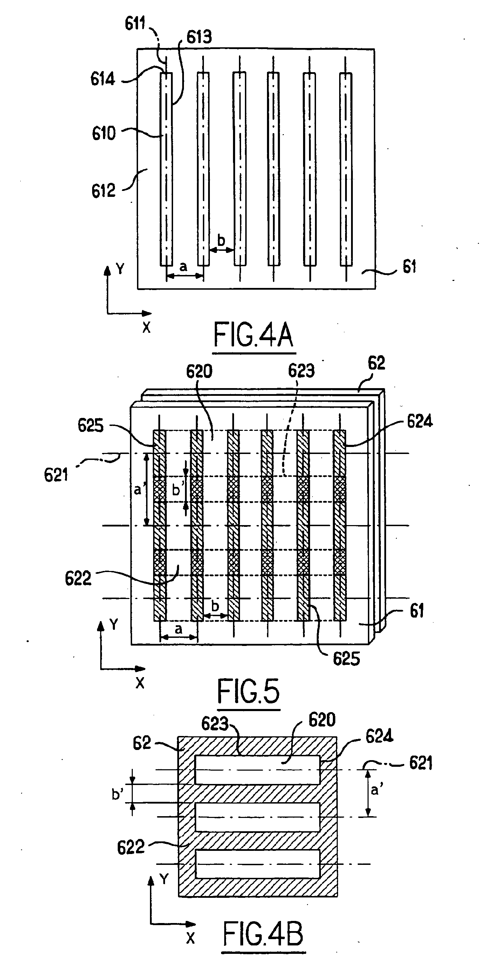

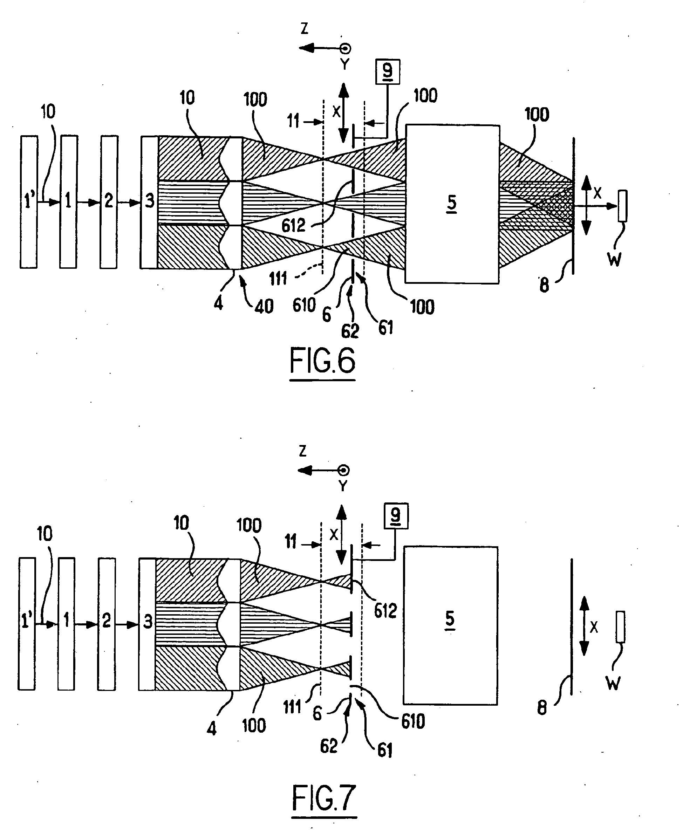

Les figures 4A et 6 montrent schématiquement qu'un obturateur 6 d'un illuminateur selon l'invention d'un dispositif de photolithographie comporte principalement au moins une plaque d'obturation 61.

Préférentiellement, la plaque d'obturation 61 est de forme carrée ou rectangulaire. La plaque 61 se compose d'une partie opaque 612 apte à obturer un faisceau lumineux 10 de photolithographie. La plaque 61 comporte également une pluralité de fentes 610 pratiquées dans la plaque aptes à laisser passer ledit faisceau lumineux.

La figure 6 montre par ailleurs qu'un illuminateur d'un dispositif de photolithographie selon l'invention comporte une source 1' du faisceau lumineux 10 pour l'illumination d'un masque 8 pour une exposition d'une zone d'une tranche W, et au moins un réseau principal 4 de microlentilles. On constate que l'illuminateur comporte également un condenseur 5 qui permet de superposer au niveau du masque 8 les sous faisceaux 100 issus du réseau 4 (le faisceau 10 est, en sortie du réseau 4, composé de sous faisceaux 100 et forme ainsi une pupille 40 de sortie du réseau 4).

Préférentiellement, le réseau 4 est constitué de deux matrices formées d'un réseau en deux dimensions de microlentilles sphériques ou cylindriques. Le réseau 4 découpe la pupille d'entrée du réseau 4 obtenue en sortie d'un ensemble formé d'un. élément diffractif 1 placé en sortie de la source 1', d'un zoom 2 et d'axicons 3. L'élément diffractif 1, le zoom 2 et les axicons 3 sont placés en amont du réseau 4 et en sortie de la source 1'.

La figure 6 montre que la plaque d'obturation 61 est située dans une zone 11 en amont ou en aval, selon une direction Z de propagation du faisceau lumineux 10 dans l'illuminateur, d'un plan de focalisation 111 du faisceau 10 - et donc des sous faisceaux 100. La focalisation des sous faisceaux 100 est effectuée par le réseau 4 formé des microlentilles. La plaque d'obturation 61 de l'obturateur 6 est ainsi située dans la zone 11 à proximité de la pupille 40 du réseau 4 principal de microlentilles.

Préférentiellement, la plaque 61 est placée du côté où l'encombrement est le moins important, à savoir entre le plan de focalisation 111 et le condenseur 5.

La profondeur de la zone 11 selon la direction Z est fonction de l'encombrement spatial de la plaque par rapport à l'espace entre le réseau 4 et le condenseur 5, mais également de la largeur des fentes.

On constate facilement sur la figure 6 que la largeur de chacune des fentes 610 doit être telle qu'elle laisse passer entièrement un sous faisceau 100 dans une première position d'exposition. Les fentes 610 laissent chacune passer un sous faisceau 100, de sorte que l'ensemble du faisceau 10 passe à travers la plaque 61 pour illuminer le masque 8 dans la première position de la figure 6. Chaque sous faisceau 100 a les caractéristiques du faisceau 10, ce qui fait que tous les sous faisceaux 100 ont les mêmes caractéristiques entre eux. Leur recombinaison au niveau du masque 8 dans un plan de focalisation du condenseur 5 permet d'obtenir le même résultat que pour les illuminateurs comportant un groupe formant relais optique.

La figure 7 montre que la plaque 61 est apte à être déplacée par rapport au faisceau 10 selon une direction X de déplacement perpendiculaire à la direction Z et parallèle à la plaque 61 pour obturer totalement le faisceau 10 dans une deuxième position d'obturation. Dans la position de la figure 7, le masque 8 n'est plus illuminé. Les sous faisceaux 100 sont obturés par la partie opaque 612 de la plaque 61 entre les fentes 610. La plaque 61 permet d'obturer chaque sous faisceau 100 juste après le réseau 4.

Des moyens 9 de déplacement de l'obturateur 6 sont aptes à déplacer la plaque 61 en synchronisme avec les déplacements du masque 8 et de la tranche W, à savoir dans le même sens, et selon une vitesse proportionnelle aux déplacements de la tranche W et du masque 8, tout en évitant que des zones ne devant pas être exposées ne le soit.

La plaque 61 obture le faisceau au moins partiellement entre les deux positions de la figure 6 et de la figure 7.

La plaque 61 est déplacée entre la position d'exposition de la figure 6 et la position d'obturation de la figure 7 en synchronisme avec les déplacements du masque 8 et de la tranche W à exposer. Ce mode d'exposition/obturation de chaque sous faisceau 100 donne le même résultat que dans l'art antérieur décrit aux figures 3A à 3E. Chaque point de la zone d'exposition de la tranche a la même énergie d'exposition que tous les autres points de la zone d'exposition lors du déplacement du masque 8 et surtout les zones de la tranche situées en dehors des zones à exposer ne sont pas exposées au faisceau 10.

La figure 4A montre que les fentes 610 de la plaque 61 ont une forme oblongue et présentent un axe longitudinal 611.

Préférentiellement, chaque fente 610 a une forme sensiblement rectangulaire. Les rectangles des fentes 610 sont définis et compris entre des grands côtés 613 et des petits côtés 614.

Préférentiellement également, les axes longitudinaux 611 des fentes 610 sont parallèles entre eux.

On définit par a la distance entre deux axes longitudinaux 611 de deux fentes successives de la plaque 61 selon la direction de déplacement X. a définit ainsi le pas des fentes 610. Elle est constante et dépend des microlentilles du réseau principal 4.

On définit par b la distance entre deux grands côtés 613 de deux fentes successives, sachant que lesdits deux grands côtés sont les plus proches et sont successifs selon la direction de déplacement X. b peut varier pour s'adapter aux conditions d'illumination du temps.

Pour un bon fonctionnement du dispositif selon l'invention, le rapport a/b doit être inférieur à deux pour la plaque 61. Avec cette valeur du rapport, le faisceau n'est pas obturé dans la première position de la figure 6, et l'obturation est totale dans la deuxième position de la figure 7.

On constate qu'avec la plaque mobile 61 l'illuminateur selon l'invention n'a plus besoin d'un groupe formant relais optique pour conjuguer le plan de l'obturateur et le masque. Le masque 8 est directement placé dans le plan de focalisation du condenseur 5, et l'obturateur 6 comportant principalement la plaque d'obturation 61 mobile est situé dans la zone 11 décrite ci-dessus.

La figure 4B montre que préférentiellement l'obturateur 6 selon l'invention comporte avantageusement une plaque croisée 62. La plaque croisée 62 comporte au moins une alternance d'une partie opaque 622 et d'une fente 620 apte à laisser passer le faisceau lumineux 10.

La plaque croisée 62 est située optiquement au droit de la plaque d'obturation 61. Pour des raisons de clarté, la plaque croisée 62 a été représentée à proximité de la plaque d'obturation 61 sur la figure 5, mais elle peut être distante de la plaque d'obturation. Ainsi, la plaque croisée 62 peut se placer au niveau du réseau principal 4, en amont ou en aval selon la direction Z d'un réseau de microlentilles. Préférentiellement, la plaque croisée 62 est située dans la zone 11 à proximité de la pupille du réseau 4 de microlentilles.

D'autres positions sont possibles pour la plaque croisée 62 en fonction des possibilités d'implantation mécanique et de l'encombrement dans l'illuminateur.

Préférentiellement chaque fente 620 de la plaque 62 croisée a une forme oblongue et un axe longitudinal 621.

Préférentiellement également, la plaque croisée 62 comporte, comme la plaque d'obturation 61, une pluralité d'alternances de parties opaques 622 et de fentes 620.

Comme le montre la figure 5, les axes longitudinaux respectifs 611 et 621 des fentes des deux plaques 61 et 62 sont perpendiculaires les uns par rapport aux autres.

Comme le montrent les figures 4B et 5 également, chaque fente 620 de la plaque croisée 62 a une fente sensiblement rectangulaire. Chaque rectangle est compris entre des grands côtés 623 et des petits côtés 624. Les axes longitudinaux 621 des fentes sont parallèles entre eux.

La figure 5 montre que lorsque la plaque croisée 62 est située au droit de la plaque 61 d'obturation, et que la plaque d'obturation 61 est dans la première position - à savoir que les fentes de la plaque 61 laissent passer le rayon 10 - les fentes 610 et 620 définissent des zones d'exposition 625. La forme et la disposition des zones 625 de l'obturateur formé des deux plaques 61 et 62 correspondent à la forme et à la disposition des différentes zones d'illumination des microlentilles du réseau 4. Le rapport des petits côtés 614 et 624 des rectangles respectivement des plaques 61 et 62 est égal à un rapport de dimension d'une microlentille du réseau 4. Autrement dit, les dimensions des zones 625 sont proportionnelles à une surface d'illumination d'une microlentille du réseau 4. Le fait que les axes longitudinaux 611 et 621 des fentes des plaques 61 et 62 sont respectivement perpendiculaires engendre qu'une plaque définit une dimension des zones d'illumination 625, l'autre plaque définissant l'autre dimension.

Comme le montrent les figures 4B et 5, on définit une distance a' entre deux axes longitudinaux 621 de deux fentes 620 successives selon une direction Y perpendiculaire à la direction de déplacement X. On définit également une distance b' entre deux grands côtés 623 desdites deux fentes successives, lesdits deux grands côtés 623 étant proches et successifs selon la direction Y.

La plaque croisée 62 est pour plus de simplicité immobile par rapport au faisceau dans un plan XY sensiblement parallèle à la plaque croisée. La plaque croisée joue sensiblement le rôle des plaques 63 et 64 d'un obturateur selon l'art antérieur et la plaque d'obturation 61 joue le rôle des plaques 65 et 66 de l'obturateur de l'art antérieur.

A titre d'exemple non limitatif, les plaques 61 et 62 ont un côté de 130 mm et une épaisseur de quelques dixièmes de millimètres. Le pas des fentes 610 et 620 est de l'ordre de quelques millimètres.

La course de la plaque 61 est de l'ordre de quelques millimètres, avec une vitesse d'environ 30 mm/s.

Les plaques peuvent être en métal ou en silice ou fluorine recouverte de chrome.

On va maintenant décrire des variantes des modes de réalisation de l'invention décrits ci-dessus.

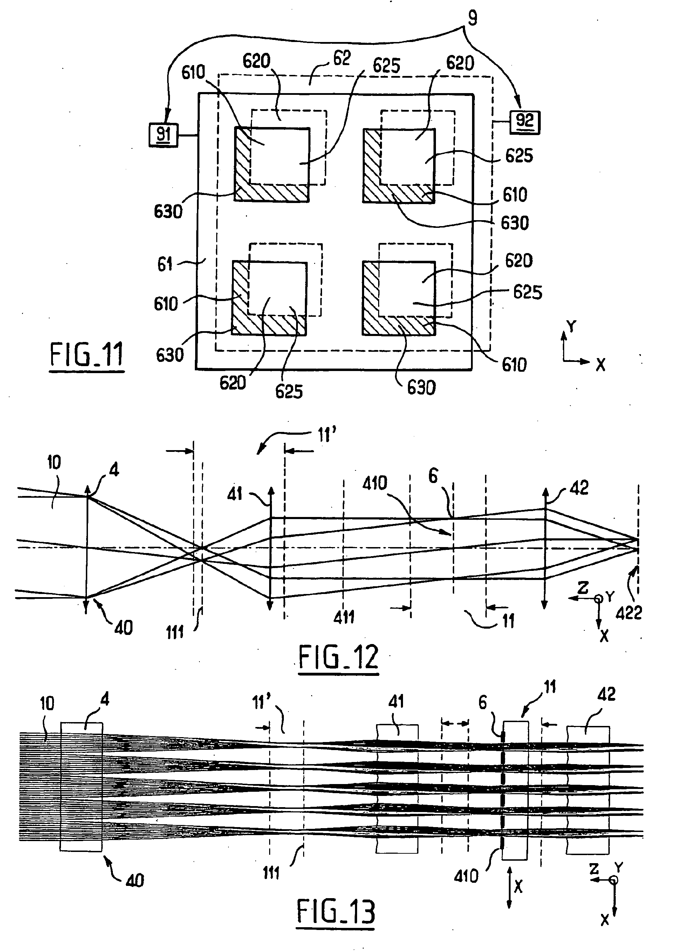

La figure 11 montre ainsi que, selon une première variante, l'obturateur peut comporter avantageusement également une plaque d'obturation 61 et une plaque croisée 62 étant mobiles par rapport à l'illumination et ayant des fentes de forme différente.

La plaque 61 d'obturation comporte une pluralité de fentes 610 pratiquées dans la plaque 61, et de même, la plaque croisée 62 comporte une pluralité de fentes 620 pratiquées dans la plaque 62.

Comme on peut le constater sur la figure 11, les fentes 610 et 620 ont sensiblement une forme de carré.

Les moyens 9 de déplacement de l'obturateur 6 comportent des moyens 91 de déplacement de la plaque 61 d'obturation, et des moyens 92 de déplacement de la plaque croisée 62. Ainsi, les déplacements de la plaque d'obturation 61 ou de la plaque croisée 62 peuvent être effectués en synchronisme avec les déplacements du masque 8 et de la tranche W.

La plaque croisée 62 est mobile par rapport au faisceau dans un plan (X, Y) sensiblement parallèle à ladite plaque croisée 62.

Préférentiellement, la plaque 61 d'obturation est également mobile selon deux directions (X, Y) sensiblement parallèles à la plaque d'obturation 61.

Ainsi, pour une exposition d'une zone d'une tranche donnée, on règle la position de la plaque croisée 62 par rapport à la plaque d'obturation 61, notamment en position sur l'axe Y. On règle ainsi la dimension, selon l'axe Y, des zones 625 transparentes au faisceau d'illumination en définissant des zones 630 opaques où au moins une zone opaque de la plaque 61 et/ou de la plaque 62 est présente.

De même que précédemment, le rapport des dimensions des zones 625 transparentes par la combinaison des fentes 610 et 620 des deux plaques 61 et 62 est égal à un rapport des dimensions d'une microlentille du réseau 4 principal.

L'obturation s'effectue ensuite, comme précédemment, en déplaçant la plaque d'obturation 61 selon l'axe des X par exemple, mais toujours en synchronisme avec les déplacements du masque 8 et de la tranche W.

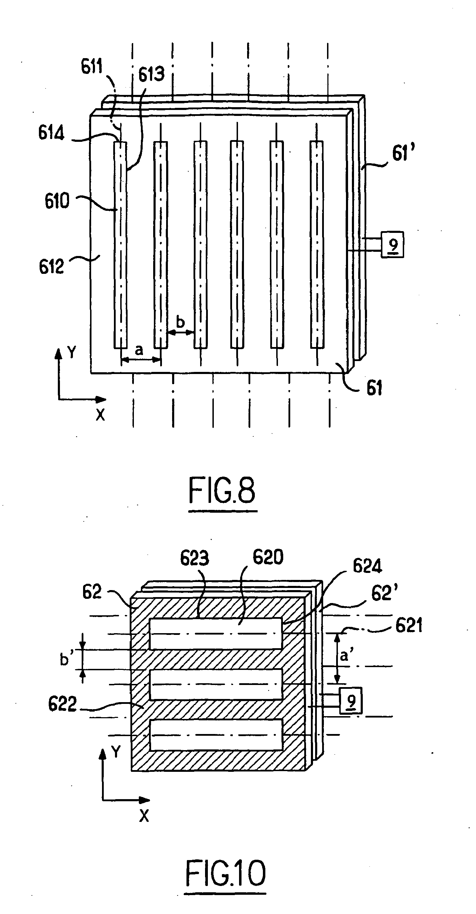

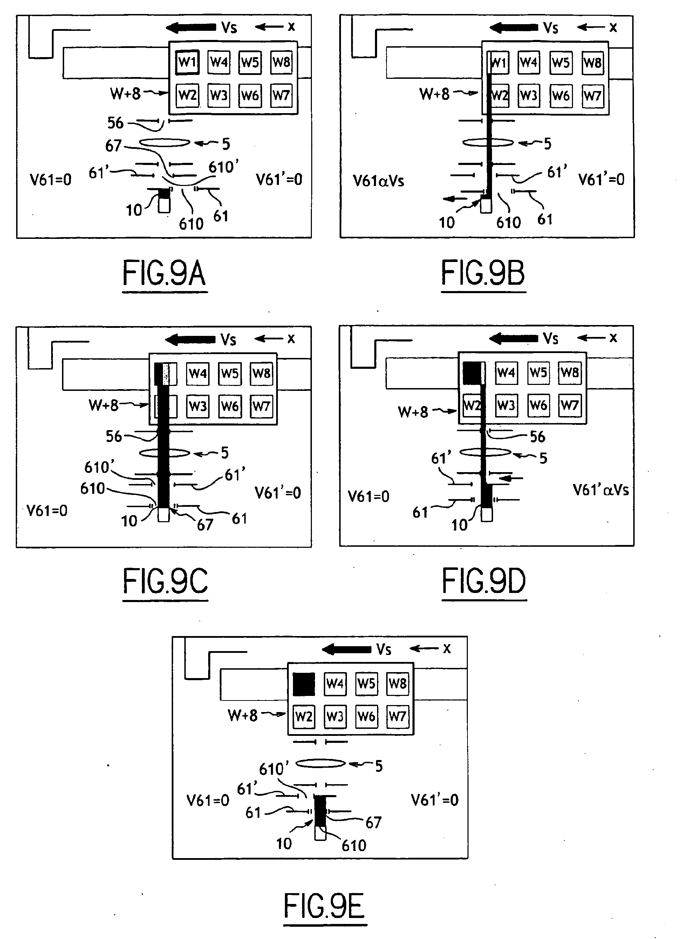

Les figures 8 et 9A à 9F montre une autre variante selon l'invention.

Selon cette variante représentée à la figure 8, l'illuminateur comporte deux plaques 61 et 61' d'obturation situées optiquement l'une en face de l'autre et mobiles l'une par rapport à l'autre par rapport au faisceau 10 selon une direction X de déplacement sensiblement parallèle aux plaques 61 et 61' d'obturation.

Les moyens 9 de déplacement sont aptes à déplacer les plaques 61 et 61' comme cela est indiqué sur les figures 9A à 9F, en synchronisme avec les déplacements du masque 8 et de la tranche W.

Lors du déplacement connu du masque 8 et de la tranche W l'un par rapport à l'autre pour une exposition en vue d'une gravure, on synchronise notamment le déplacement des plaques 61 et 61' avec les déplacements du masque 8 et de la tranche W.

Sur les figures 9A à 9E, on a représenté pour plus de clarté que le masque 8 était situé sur la tranche W Bien entendu, le masque est optiquement situé au droit de la tranche W. Pour plus de clarté également, on n'a représenté que la combinaison d'une fente 610 et 610' respectivement de chaque plaque 61 et 61', mais les plaques 61 et 61' comportent une pluralité de fentes.

La figure 9A montre que lorsque la tranche W et le masque 8 se déplacent selon la direction X mais se trouvent en dehors de la zone d'exposition 56 définie par le condenseur 5, alors les fentes 610 et 610' des plaques 61 et 61' sont positionnées les unes par rapport aux autres de telle sorte que l'aire 67 soit nulle. Le faisceau 10 est bloqué par l'obturateur.

La figure 9B montre que lorsque le bord gauche du masque 8 définissant la première zone W1 de la tranche W à exposer arrive avec la vitesse Vs au niveau du bord gauche de la fente 610 de la plaque 61, alors cette dernière commence un déplacement en synchronisme avec les déplacements du masque 8 et de la tranche W, à savoir dans le même sens que le masque 8 avec une vitesse proportionnelle à la vitesse Vs. Les zones de la tranche W situées en dehors de la zone W1 à exposer ne sont ainsi pas exposées au faisceau 10.

La figure 9C montre que la plaque 61 suit le masque 8 jusqu'à ce que le bord gauche du masque 8 soit situé au niveau du bord gauche de la zone d'exposition 56. L'aire 67 est alors maximale et l'ensemble du faisceau 10 expose la zone W1 à travers la zone 56.

La figure 9D montre que c'est alors la plaque 61' qui suit le masque 8 dans le même sens que le masque 8 sur la direction X lorsque le bord droit du masque dépasse le bord droit de la zone 56. Encore une fois, le déplacement de la plaque 61' s'effectue en synchronisme avec les déplacements de la tranche W et du masque 8, à savoir dans le même sens et avec une vitesse proportionnelle à la vitesse Vs de la tranche W. De cette manière, les zones de la tranche W situées en dehors de la zone W1 ne sont pas exposées au faisceau 10.

La figure 9E correspond à la fermeture de l'aire 67 d'exposition, le bord droit de la fente 610' de la plaque 61' et le bord gauche de la fente 610 de la plaque 61 sont alors jointifs. La zone W1 est en dehors de la zone 56 et le faisceau 10 est bloqué par l'obturateur.

Lors du déplacement du masque dans l'autre sens selon X, par exemple pour une exposition des zones W2 à W8, les plaques 61 et 61' se déplacent bien entendu dans l'autre sens.

Grâce à ce procédé d'ouverture et de fermeture des plaques 61 et 61', tous les points de la zone à graver reçoivent la même énergie d'exposition et les zones ne devant pas être exposées ne le sont pas.

Selon une variante de l'invention, la plaque croisée 62 du mode de réalisation de la figure 11 joue le rôle de la plaque 61'.

Selon une autre variante représentée à la figure 10, l'illuminateur comporte deux plaques 62 et 62' croisées situées optiquement l'une en face de l'autre et mobiles l'une par rapport à l'autre par rapport au faisceau 10 selon une direction Y de déplacement sensiblement parallèle aux plaques 62 et 62' croisées. La direction de déplacement des plaques croisées 62 et 62' est perpendiculaire à la direction X de déplacement d'au moins une plaque 61 d'obturation placée au droit des plaques 62 et 62'.

Les moyens 9 de déplacement sont aptes à déplacer les plaques 62 et 62'. Cela permet notamment de régler la dimension de l'aire d'exposition selon la direction Y.

Les figures 12 et 13 montrent schématiquement une autre variante selon laquelle l'illuminateur comporte au moins un réseau 41 de microlentilles de création d'une pupille 410.

La référence 111 correspond au plan de focalisation du réseau 4 principal.

Le réseau 41 de création est situé dans une zone 11' à proximité du plan 111 de focalisation du faisceau 10 par le réseau 4 principal de microlentilles. Le réseau 41 de création est situé en aval du réseau 4 principal de microlentilles, mais en amont de l'obturateur 6.

Le réseau 41 permet de réimager la pupille 40 du réseau principal 4. Le faisceau 10 n'est en effet pas parfaitement collimaté, ce qui peut poser des problèmes de coupure franche de l'illumination au niveau du masque 8.

L'obturateur 6 est donc placé dans une zone 11 à proximité de la pupille 410 du système optique comportant le réseau principal 4 et le réseau 41 de création, ce qui permet une coupure franche du faisceau et une obturation bien nette au niveau du masque 8.

Ainsi, selon l'invention, l'obturateur est placé dans une zone 11 à proximité d'une pupille système optique ne comportant que le réseau principal lorsque le réseau principal n'est pas associé à un autre réseau de microlentilles, ou à proximité d'une pupille de sortie du système optique comportant le réseau principal et le réseau de création situé en aval du réseau principal pour réimager la pupille du réseau principal.

L'obturateur 6 est bien entendu placé, comme dans tous les modes de réalisation déjà décrits, dans un plan conjugué du plan du masque 8 et du plan de la tranche W.

Préférentiellement, l'illuminateur comporte un réseau 42 de microlentilles d'homogénéisation situé en aval de l'obturateur 6 et en amont d'un condenseur 5. Le réseau 42 permet également de rendre l'illuminateur télécentrique. La référence 422 correspond au plan objet du condenseur 5.

L'obturateur est placé dans une zone à proximité d'une pupille intermédiaire 410 du système optique composé du réseau 4 principal, du réseau 41 de création et du réseau 42 d'homogénéisation. Il peut également être situé dans une zone à proximité d'une pupille de sortie d'un système optique comportant le réseau principal, le réseau de création et le réseau d'homogénéisation.

De plus, très avantageusement, le profil d'illumination du masque doit être trapézoïdal selon la direction de déplacement du masque et de la tranche.

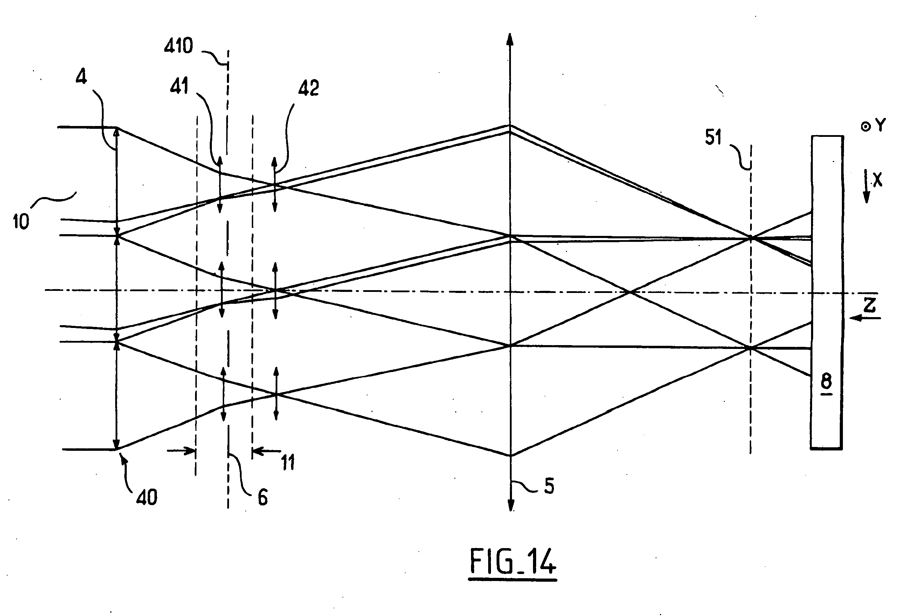

Afin d'obtenir le profil d'illumination trapézoïdal souhaité, le masque 8 est défocalisé par rapport à un plan 51 de focalisation du condenseur 5 dans la direction Z, perpendiculaire au plan de l'obturateur et à la direction X de déplacement du masque 8, comme le montre la figure 14. Une telle défocalisation permet notamment de corriger certains défauts de l'illumination dus à la nature de la source de l'illumination, notamment lorsque la source est un laser.

Une telle défocalisation peut cependant poser des problèmes de coupure franche de l'illumination au niveau du masque.

Ainsi avantageusement, un pas des fentes 610 de la plaque 61 d'obturation de l'obturateur 6 est supérieur à un pas du réseau 4 principal de microlentilles dans une direction sensiblement parallèle à une direction de déplacement du masque 8. Une telle différence de pas crée un léger décalage sur le moment où chaque partie opaque vient couper le faisceau issu du réseau 4 qui lui correspond.

Dans le cas où l'illuminateur comporte un réseau 41 de microlentilles de création d'une pupille 410 et/ou un réseau d'homogénéisation 42, pour ne pas perdre le bénéfice de la coupure franche apportée par la présence avantageuse du réseau de création 41, un pas des fentes 610 de la plaque 61 d'obturation de l'obturateur 6 est supérieur à un pas du réseau 41 de création dans une direction sensiblement parallèle à une direction de déplacement du masque 8, et préférentiellement supérieur à un pas du réseau 42 dans la même direction.

Les variantes décrites ci-dessus peuvent être couplées entre elles, l'obturateur peut ainsi comporter deux plaques d'obturation et deux plaques croisées, comporter ou non un réseau 41 de création d'une pupille 410, et comporter ou non un masque défocalisé dans le plan 51.

Dans tous les développements qui précèdent, chaque plaque croisée 62 est située préférentiellement dans une zone 11 à proximité d'une pupille d'un système comportant le réseau 4 principal de microlentilles, optiquement en face de la plaque 61 d'obturation.

On a décrit des fentes pratiquées dans les plaques, mais une pluralité de parties transparentes au faisceau a évidemment la même fonction, à la condition que les parties transparentes sont totalement transparentes au faisceau et les parties opaques bloquent complètement le faisceau.

Dans tous les cas, le déplacement de l'obturateur s'effectue avec une précision de l'ordre du micron, le fait que l'obturateur est composé de plaques facilite un tel déplacement précis.

## Revendications

1. Illuminateur d'un dispositif de photolithographie, comportant
- une source (1') d'un faisceau (10) lumineux pour l'illumination d'un masque (8) et pour une exposition d'une zone d'une tranche (W).
- au moins un réseau (4) principal de microlentilles, et
- un obturateur (6) comportant au moins une plaque d'obturation (61), la plaque (61) comportant
au moins une partie opaque (612) au faisceau lumineux (10), et
une pluralité de parties (610) transparentes au faisceau, la plaque (61) étant apte à être déplacée par rapport au faisceau (10) selon une direction (X) de déplacement sensiblement parallèle à la plaque, de sorte que
la partie opaque (612) puisse obturer au moins partiellement le faisceau lumineux, ou de sorte que
les parties transparentes puissent laisser passer au moins partiellement ledit faisceau lumineux (10),
- des moyens (9) de déplacement aptes à déplacer l'obturateur (6) en synchronisme avec les déplacements du masque (8) et de la tranche (W) ; **ledit illuminateur étant caractérisé en ce qu'il comporte**
au moins un réseau (41) de microlentilles de création d'une pupille (410) image de la pupille du réseau principal (4), le réseau (41) de création étant situé en aval dudit réseau (4) principal de microlentilles mais en amont de l'obturateur (6), l'obturateur (6) étant situé dans une zone (11) à proximité de ladite pupille (410) image.

2. Illuminaleur selon la revendication précédente, dans lequel les parties transparentes (610) ont chacune une forme oblongue et un axe longitudinal (611).

3. Illuminateur selon la revendication précédente, dans lequel les parties transparentes (610) ont chacune une forme sensiblement rectangulaire, chaque rectangle étant compris entre des grands côtés (613) et des petits côtés (614), les axes longitudinaux des parties transparentes étant parallèles entre eux.

4. Illuminateur selon la revendication précédente, dans lequel la valeur du rapport (a/b) entre d'une part la distance (a) entre deux axes longitudinaux (611) de deux parties transparentes successives selon la direction de déplacement (X) et d'autre part la distance (b) entre deux grands côtés (613) desdites deux parties transparentes successives, lesdits deux grands côtés étant proches et successifs selon la direction de déplacement (X), est inférieure à deux.

5. Illuminateur selon l'une des revendications précédentes, dans lequel l'obturateur (6) comporte en outre au moins une plaque croisée (62) située optiquement en face de la plaque d'obturation (61), la plaque croisée (62) comportant au moins une alternance d'une partie opaque (622) au faisceau lumineux (10) et d'une partie transparente (620) apte à le laisser passer.

6. Illuminateur selon la revendication précédente, dans lequel la partie transparente de la plaque croisée (62) a une forme oblongue et un axe longitudinal (621).

7. Illuminateur selon la revendication précédente, dans lequel la plaque croisée (62) comporte une pluralité d'alternances.

8. Illuminateur selon la revendication précédente lorsqu'elle dépend de la revendication 3, dans lequel les axes longitudinaux respectifs (611, 621) des parties transparentes des deux plaques (61, 62) sont perpendiculaires les uns par rapport aux autres.

9. Illuminateur selon l'une des revendications 5 à 8, dans lequel chaque partie transparente (620) de la plaque croisée (62) a une forme sensiblement rectangulaire, chaque rectangle étant compris entre des grands côtés (623) et des petits côtés (624), les axes longitudinaux (622) dés parties transparentes étant parallèles entre eux.

10. Illuminateur selon l'une des revendications 5 à 9, dans lequel la plaque croisée (62) est immobile par rapport au faisceau dans un plan (X, Y) sensiblement parallèle à ladite plaque croisée (62).

11. Illuminateur selon l'une des revendications 5 à 9, dans lequel les moyens de déplacement de l'obturateur comportent des moyens (91) de déplacement de la plaque (61) d'obturation et des moyens (92) de déplacement de la plaque croisée (62), les déplacements de la plaque d'obturation (61) pouvant être effectués en synchronisme avec les déplacements du masque (8) et de la tranche (W), la plaque croisée (62) étant mobile par rapport au faisceau dans un plan (X, Y) sensiblement parallèle à ladite plaque croisée (62).

12. Illuminateur selon la revendication précédente, dans lequel la plaque (61) d'obturation est mobile selon deux directions (X, Y) sensiblement parallèles à la plaque d'obturation (61).

13. Illuminateur selon l'une des revendications 5 à 12, dans lequel la plaque croisée (62) est située dans une zone (11) à proximité d'une pupille (40, 410) d'un système optique comportant au moins le réseau (4) principal de microlentilles, optiquement en face de la plaque (61) d'obturation.

14. Illuminateur selon les revendications 9 à 13, dans lequel le rapport des petits côtés (614, 624) des rectangles formant les parties transparentes (610, 620) des deux plaques (61, 62) ou la combinaison des parties transparentes des deux plaques est égal à un rapport des dimensions d'une microlentille du réseau (4).

15. Illuminateur selon l'une des revendications 1 à 14, comportant deux plaques (61, 61') d'obturation situées optiquement l'une en face de l'autre et mobiles l'une par rapport à l'autre par rapport au faisceau (10) selon une direction (X) de déplacement sensiblement parallèle aux plaques (61, 61') d'obturation.

16. Illuminateur selon l'une des revendications 5 à 15, comportant deux plaques (62, 62') croisées situées optiquement l'une en face de l'autre et mobiles l'une par rapport à l'autre par rapport au faisceau (10) selon une direction (Y) de déplacement sensiblement parallèle aux plaques (62, 62') croisées, la direction de déplacement des plaques croisées étant perpendiculaire à la direction (X) de déplacement d'au moins une plaque (61) d'obturation.

17. Illuminateur selon la revendication 1, comportant un réseau (42) de microlentilles d'homogénéisation situé en aval de l'obturateur (6) et en amont d'un condenseur (5).

18. Dispositif de photolithographie comportant un illuminateur, et un masque (8), **caractérisé en ce que** l'illuminateur est selon l'une des revendications 1 à 17 et comporte en outre un condenseur (5) situé en amont du masque (8).

19. Dispositif selon la revendication précédente, dans lequel le masque (8) est défocalisé dans un plan (51) de focalisation du condenseur (5) selon une direction (Z) perpendiculaire à une direction de déplacement du masque (8).

20. Dispositif selon la revendication précédente, dans lequel un pas des parties transparentes (610) de la plaque (61) d'obturation est supérieur à un pas du réseau (4) principal de microlentilles dans une direction sensiblement parallèle à une direction de déplacement du masque (8).

21. Dispositif selon la revendication précédente, dans lequel l'illuminateur comporte au moins un réseau (41) de microlentilles de création d'une pupille image (410) de la pupille du réseau principal (4), le réseau (41) de création étant situé en aval dudit réseau (4) principal de microlentilles mais en amont de l'obturateur (6), un pas des parties transparentes (610) de la plaque (61) d'obturation étant supérieur à un pas du réseau (41) de création dans une direction sensiblement parallèle à une direction de déplacement du masque (8).

22. Dispositif selon l'une des revendications 20 ou 21, dans lequel l'illuminateur comporte au moins un réseau (42) de microlentilles d'homogénéisation, le réseau (42) d'homogénéisation étant situé en aval du réseau (4) principal de microlentilles mais en amont du condenseur (5), un pas des parties transparentes (610) de la plaque (61) d'obturation étant supérieur à un pas du réseau (42) d'homogénéisation dans une direction sensiblement parallèle à une direction de déplacement du masque (8).

## Claims

1. Illuminator of a photolithography device, comprising:
- a source (1') of a light beam (10) for illuminating a mask (8) and for exposing a zone of a wafer (W),
- at least one main microlens array (4), and
- a shutter (6) comprising at least one shutter plate (61), which plate (61) comprises
at least one portion (612) opaque to the light beam (10), and
a plurality of portions (610) transparent to the beam,
wherein the plate (61) is capable of being moved with respect to the beam (10) in a direction (X) of movement substantially parallel to the plate, so that
the opaque portion (612) can at least partially block the light beam, or so that
the transparent portions can allow said light beam (10) at least partially to pass through,
- movement means (9) capable of moving the shutter (6) in synchrony with the movements of the mask (8) and the wafer (W);
said illuminator **characterised in that** it comprises
at least one array (41) of microlenses for creating a pupil image (410) of the pupil of the main array (4), wherein the creation array (41) is located downstream of said main microlens array (4) but upstream of the shutter (6), wherein the shutter (6) is located in a zone (11) near said pupil (410) image.

2. Illuminator according to the previous claim, in which the transparent portions (610) each have an oblong shape and a longitudinal axis (611).

3. Illuminator according to the previous claim, in which the transparent portions (610) each has a substantially rectangular shape, wherein each rectangle is contained between large sides (613) and small sides (614), and the longitudinal axes of the transparent portions are parallel to one another.

4. Illuminator according to the previous claim, in which the value of the ratio (a/b) between the distance (a) between two longitudinal axes (611) of two successive transparent portions in the direction of movement (X) and the distance (b) between two large sides (613) of said two successive transparent portions, with said two large sides being close and successive in the direction of movement (X), is less than two.

5. Illuminator according to one of the previous claims, in which the shutter (6) also comprises at least one cross-plate (62) optically located opposite the shutter plate (61), wherein the cross-plate (62) comprises at least one alternation of a portion (622) opaque to the light beam (10) and a transparent portion (620) capable of allowing it to pass through.

6. Illuminator according to the previous claim, in which the transparent portion of the cross-plate (62) has an oblong shape and a longitudinal axis (621).

7. Illuminator according to the previous claim, in which the cross-plate (62) comprises a plurality of alternations.

8. Illuminator according to the previous claim when it is dependent on claim 3, in which the respective longitudinal axes (611, 621) of the transparent portions of the two plates (61, 62) are perpendicular to one another.

9. Illuminator according to one of claims 5 to 8, in which each transparent portion (620) of the cross-plate (62) has a substantially rectangular shape, each rectangle is contained between large sides (623) and small sides (624), and the longitudinal axes (622) of the transparent portions are parallel to one another.

10. Illuminator according to one of claims 5 to 9, in which the cross-plate (62) is immobile with respect to the beam in a plane (X, Y) substantially parallel to said cross-plate (62).

11. Illuminator according to one of claims 5 to 9, in which the shutter movement means comprise means (91) for moving the shutter plate (61) and means (92) for moving the cross-plate (62), wherein the movements of the shutter plate (61) can be made in synchrony with the movements of the mask (8) and the wafer (W), and the cross-plate (62) is mobile with respect to the beam in a plane (X, Y) substantially parallel to said cross-plate (62).

12. Illuminator according to the previous claim, in which the shutter plate (61) is mobile in two directions (X, Y) substantially parallel to the shutter plate (61).

13. Illuminator according to one of claims 5 to 12, in which the cross-plate (62) is located in a zone (11) near a pupil (40, 410) of the optical system comprising at least the main microlens array (4), optically opposite the shutter plate (61).

14. Illuminator according to claims 9 to 13, in which the ratio of the small sides (614, 624) of the rectangles forming the transparent portions (610, 620) of the two plates (61, 62) or the combination of the transparent portions of the two plates is equal to a ratio of the dimensions of a microlens of the array (4).

15. Illuminator according to one of claims 1 to 14, comprising two shutter plates (61, 61') optically located opposite one another and mobile, one with respect to the other, with respect to the beam (10) in a direction (X) of movement substantially parallel to the shutter plates (61, 61').

16. Illuminator according to one of claims 5 to 15, comprising two shutter plates (62, 62') optically located opposite one another and mobile, one with respect to the other, with respect to the beam (10) in a direction (Y) of movement substantially parallel to the cross-plates (62, 62'), with the direction of movement of the cross-plates being perpendicular to the direction (X) of movement of at least one shutter plate (61).

17. Illuminator according to claims 1, comprising an array (42) of standardization microlenses located downstream of the shutter (6) and upstream of a condenser (5).

18. Photolithography device comprising an illuminator and a mask (8), **characterized in that** the illuminator is according to one claims 1 to 17 and comprises a condenser (5) located upstream of the mask (8).

19. Device according to the previous claim, in which the mask (8) is defocused in a focusing plane (51) of the condenser (5) in a direction (Z) perpendicular to a direction of movement of the mask (8).

20. Device according to the previous claim, in which a step of the transparent portions (610) of the shutter plate (61) is greater than a step of the main microlens array (4) in a direction substantially parallel to a direction of movement of the mask (8).

21. Device according to the previous claim, in which the illuminator comprises at least one array (41) of microlenses for creating a pupil image (410) of the pupil of the main array (4), wherein the creation array (41) is located downstream of said main microlens array (4) but upstream of the shutter (6), and a step of the transparent portions (610) of the shutter plate (61) is greater than a step of the creation array (41) in a direction substantially parallel to a direction of movement of the mask (8).

22. Device according to one of claims 20 or 21, in which the illuminator comprises at least one array (42) of standardization microlenses, wherein the standardization array (42) is located downstream of the main microlens array (4) but upstream of the condenser (5), and a step of the transparent portions (610) of the shutter plate (61) is greater than a step of the standardization array (42) in a direction substantially parallel to a direction of movement of the mask (8).

## Patentansprüche

1. Illuminator einer Photolithographievorrichtung, umfassend
- eine Quelle (1') eines Lichtbündels (10) für die Beleuchtung einer Maske (8) und für eine Belichtung eines Bereichs einer Scheibe (W),
- mindestens ein Mikrolinsen-Hauptarray (4), und
- einen Verschluss (6), der mindestens eine Verschlussplatte (61) umfasst, wobei die Platte (61)
mindestens einen für das Lichtbündel (10) undurchlässigen Teil (612) und
mehrere für das Bündel durchlässige Teile (610) umfasst,
wobei die Platte (61) imstande ist, in Bezug auf das Bündel (10) gemäß einer Verschiebungsrichtung (X), die im Wesentlichen parallel zur Platte verläuft, verschoben zu werden, so dass
der lichtundurchlässige Teil (612) das Lichtbündel zumindest teilweise verschließen kann, oder so dass
die durchlässigen Teile das Lichtbündel (10) zumindest teilweise durchlassen können,
- Verschiebungsmittel (9), die imstande sind, den Verschluss (6) im Gleichlauf mit den Verschiebungen der Maske (8) und der Scheibe (W) zu verschieben;
wobei der Illuminator **dadurch gekennzeichnet ist, dass** er mindestens ein Mikrolinsenarray (41) zur Erstellung einer Pupillenabbildung (410) der Pupille des Hauptarrays (4) umfasst, wobei das Array (41) zur Erstellung dem Mikrolinsen-Hauptarray (4) nachgelagert, aber dem Verschluss (6) vorgelagert ist, wobei der Verschluss (6) in einem Bereich (11) in der Nähe der Pupillenabbildung (410) angeordnet ist.

2. Illuminator nach dem vorhergehenden Anspruch, wobei die durchlässigen Teile (610) jeweils eine längliche Form und eine Längsachse (611) aufweisen.

3. Illuminator nach dem vorhergehenden Anspruch, wobei die durchlässigen Teile (610) jeweils eine im Wesentlichen rechteckige Form aufweisen, wobei jedes Rechteck zwischen Langseiten (613) und Kurzseiten (614) eingeschlossen ist, wobei die Längsachsen der durchlässigen Teile parallel zueinander verlaufen.

4. Illuminator nach dem vorhergehenden Anspruch, wobei der Wert des Verhältnisses (a/b) zwischen einerseits dem Abstand (a) zwischen zwei Längsachsen (611) von zwei gemäß der Verschiebungsrichtung (X) aufeinander folgenden durchlässigen Teilen und andererseits dem Anstand (b) zwischen zwei Langseiten (613) der beiden aufeinander folgenden durchlässigen Teile, wobei die zwei Langseiten nahe beieinander liegen und gemäß einer Verschiebungsrichtung (X) aufeinander folgen, kleiner als zwei ist.

5. Illuminator nach einem der vorhergehenden Ansprüche, wobei der Verschluss (6) ferner mindestens eine Kreuzplatte (62) umfasst, die sich optisch gegenüber der Verschlussplatte (61) befindet, wobei die Kreuzplatte (62) mindestens eine Abfolge von einem für das Lichtbündel (10) undurchlässigen Teil (622) und einem durchlässigen Teil (620) umfasst, der imstande ist, es durchzulassen.

6. Illuminator nach dem vorhergehenden Anspruch, wobei der durchlässige Teil der Kreuzplatte (62) eine längliche Form und eine Längsachse (621) aufweist.

7. Illuminator nach dem vorhergehenden Anspruch, wobei die Kreuzplatte (62) mehrere Abfolgen umfasst.

8. Illuminator nach dem vorhergehenden Anspruch, wenn dieser von Anspruch 3 abhängig ist, wobei die jeweiligen Längsachsen (611, 621) der durchlässigen Teile der beiden Platten (61, 62) senkrecht zueinander verlaufen.

9. Illuminator nach einem der Ansprüche 5 bis 8, wobei jeder durchlässige Teil (620) der Kreuzplatte (62) eine im Wesentlichen rechteckige Form aufweist, wobei jedes Rechteck zwischen Langseiten (623) und Kurzseiten (624) eingeschlossen ist, wobei die Längsachsen (622) der durchlässigen Teile parallel zueinander verlaufen.

10. Illuminator nach einem der Ansprüche 5 bis 9, wobei die Kreuzplatte (62) in Bezug auf das Bündel in einer Ebene (X, Y), die im Wesentlichen parallel zur Kreuzplatte (62) verläuft, feststehend ist.

11. Illuminator nach einem der Ansprüche 5 bis 9, wobei die Mittel zur Verschiebung des Verschlusses Mittel (91) zur Verschiebung der Verschlussplatte (61) und Mittel (92) zur Verschiebung der Kreuzplatte (62) umfassen, wobei die Verschiebungen der Verschlussplatte (61) im Gleichlauf mit den Verschiebungen der Maske (8) und der Scheibe (W) durchgeführt werden können, wobei die Kreuzplatte (62) in Bezug auf das Bündel in einer Ebene (X, Y), die im Wesentlichen parallel zur Kreuzplatte (62) verläuft, beweglich ist.

12. Illuminator nach dem vorhergehenden Anspruch, wobei die Verschlussplatte (61) gemäß zweier Richtungen (X, Y), die im Wesentlichen parallel zur Verschlussplatte (61) verlaufen, beweglich ist.

13. Illuminator nach einem der Ansprüche 5 bis 12, wobei sich die Kreuzplatte (62) in einem Bereich (11) in der Nähe einer Pupille (40, 410) eines optischen Systems befindet, das zumindest das Mikrolinsen-Hauptarray (4) umfasst, optisch gegenüber der Verschlussplatte (61).

14. Illuminator nach einem der Ansprüche 9 bis 13, wobei das Verhältnis der Kurzseiten (614, 624) der Rechtecke, welche die durchlässigen Teile (610, 620) der beiden Platten (61, 62) bilden, oder die Kombination der durchlässigen Teile der beiden Platten gleich ist wie ein Verhältnis der Abmessungen einer Mikrolinse des Arrays (4).

15. Illuminator nach einem der Ansprüche 1 bis 14, umfassend zwei Verschlussplatten (61, 61'), die optisch eine der anderen gegenüber angeordnet sind und zueinander in Bezug auf das Bündel (10) gemäß einer Verschiebungsrichtung (X), die im Wesentlichen parallel zu den Verschlussplatten (61, 61') verläuft, beweglich sind.

16. Illuminator nach einem der Ansprüche 5 bis 15, umfassend zwei Kreuzplatten (62, 62'), die optisch eine der anderen gegenüber angeordnet sind und zueinander in Bezug auf das Bündel (10) gemäß einer Verschiebungsrichtung (Y), die im Wesentlichen parallel zu den Kreuzplatten (62, 62') verläuft, beweglich sind, wobei die Verschiebungsrichtung der Kreuzplatten senkrecht zur Verschiebungsrichtung (X) von mindestens einer Verschlussplatte (61) verläuft.

17. Illuminator nach Anspruch 1, umfassend ein Mikrolinsenarray (42) zur Homogenisierung, das dem Verschluss (6) nachgelagert und einem Kondensor (5) vorgelagert ist.

18. Photolithographievorrichtung umfassend einen Illuminator und eine Maske (8), **dadurch gekennzeichnet, dass** der Illuminator einem der Ansprüche 1 bis 17 entspricht und ferner einen Kondensor (5) umfasst, welcher der Maske (8) vorgelagert ist.

19. Vorrichtung nach dem vorhergehenden Anspruch, wobei die Maske (8) in einer Fokussierungsebene (51) des Kondensors (5) gemäß einer Richtung (Z), die senkrecht zu einer Verschiebungsrichtung der Maske (8) verläuft, defokussiert ist.

20. Vorrichtung nach dem vorhergehenden Anspruch, wobei ein Mittenabstand der durchlässigen Teile (610) der Verschlussplatte (61) größer ist als ein Mittenabstand des Mikrolinsen-Hauptarrays (4), und zwar in einer Richtung, die im Wesentlichen parallel zu einer Verschiebungsrichtung der Maske (8) verläuft.

21. Vorrichtung nach dem vorhergehenden Anspruch, wobei der Illuminator mindestens ein Mikrolinsenarray (41) zur Erstellung einer Pupillenabbildung (410) der Pupille des Hauptarrays (4) umfasst, wobei das Array (41) zur Erstellung dem Mikrolinsen-Hauptarray (4) nachgelagert, aber dem Verschluss (6) vorgelagert ist, wobei ein Mittenabstand der durchlässigen Teile (610) der Verschlussplatte (61) größer ist als ein Mittenabstand des Arrays (41) zur Erstellung, und zwar in einer Richtung, die im Wesentlichen parallel zu einer Verschiebungsrichtung der Maske (8) verläuft.

22. Vorrichtung nach einem der Ansprüche 20 oder 21, wobei der Illuminator mindestens ein Mikrolinsenarray (42) zur Homogenisierung umfasst, wobei das Array (42) zur Homogenisierung dem Mikrolinsen-Hauptarray (4) nachgelagert, aber dem Kondensor (5) vorgelagert ist, wobei ein Mittenabstand der durchlässigen Teile (610) der Verschlussplatte (61) größer ist als ein Mittenabstand des Arrays (42) zur Homogenisierung, und zwar in einer Richtung, die im Wesentlichen parallel zu einer Verschiebungsrichtung der Maske (8) verläuft.
